Europäisches Patentamt

European Patent Office

Office européen des brevets

(19)

(11) Numéro de publication : **0 493 236 A1**

## (12) DEMANDE DE BREVET EUROPEEN

(21) Numéro de dépôt : **91403510.0**

(22) Date de dépôt : **20.12.91**

(51) Int. Cl.$^5$ : **H03H 11/22**

(30) Priorité : **28.12.90 FR 9016434**

(43) Date de publication de la demande :
**01.07.92 Bulletin 92/27**

(84) Etats contractants désignés :
**BE CH DE ES GB IT LI LU NL SE**

(71) Demandeur : **THOMSON COMPOSANTS MICROONDES**
**51, Esplanade du Général de Gaulle**
**F-92800 Puteaux (FR)**

(72) Inventeur : **Magarshack, John**
**THOMSON-CSF, SCPI, Cédex 67**
**F-92045 Paris la Défense (FR)**

(74) Mandataire : **Taboureau, James et al**
**THOMSON-CSF SCPI**
**F-92045 Paris La Défense Cédex 67 (FR)**

(54) **Procédé de déphasage d'un signal électrique, et déphaseur basé sur ce procédé.**

(57)    L'invention concerne un procédé de déphasage d'un signal électrique (E), ayant une phase et une amplitude déterminée.

La fonction de base de ce procédé comporte :
— une opération de sommation vectorielle ($\Sigma$) de deux signaux d'entrée (E1,E2) de phases différentes mais de même amplitude,
— une opération de normalisation de l'amplitude de la somme vectorielle ($\Sigma 1$)
— une opération de sélection (C) de l'un parmi les trois signaux (E1,E2,$\Sigma 1$), qui ont des phases différentes.

Le déphaseur opère par itérations successives, jusqu'à obtenir l'angle de déphasage désiré.

Application aux radars, télécommunications ... essentiellement dans le domaine des hyperfréquences.

FIG.13

EP 0 493 236 A1

Jouve, 18, rue Saint-Denis, 75001 PARIS

La présente invention concerne un procédé de déphasage numérique d'un signal électrique analogique. Il s'applique à toutes les fréquences de signaux, mais est plus particulièrement adapté aux hyperfréquences, ou microondes. L'invention concerne également le déphaseur construit conformément à ce procédé de déphasage.

Dans de nombreux cas, on a besoin de disposer d'un signal électrique, ayant une certaine phase, et du même signal électrique mais ayant une autre phase, en avance ou en retard. C'est le cas par exemple des modems, ou modulateurs-démodulateurs de phase PSK - pour Phase Shift Keying - en télecommunications, ou des modules pour antennes à balayage électronique, en radars. Dans la plupart des cas, les fréquences utilisées se situent dans la gamme des fréquences intermédiaires (en MHZ) jusqu'aux microondes (en GHz) et les déphaseurs sont soit peu tolérants aux dispersions technologiques, soit limités en largeur de bande passante.

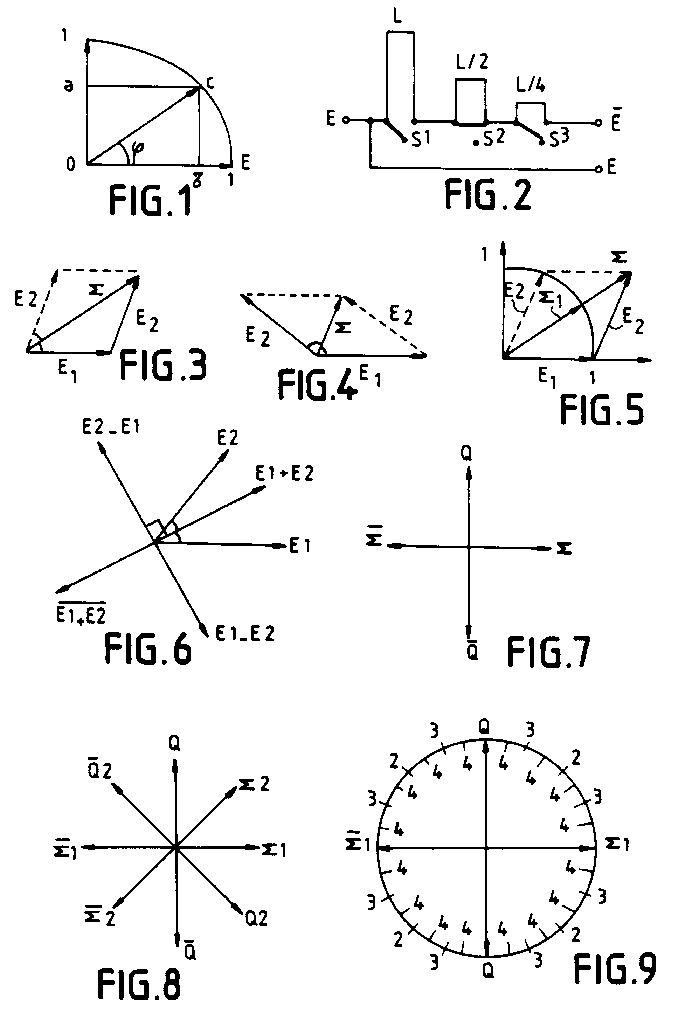

Il est connu d'utiliser un déphaseur analogique dont le fondement est donné en figure 1. Si OE est un vecteur représentatif du signal d'entrée E, d'amplitude 1 et de phase nulle, on sait obtenir un signal déphasé représenté par le vecteur "c", d'amplitude 1 et de phase $\varnothing$, en contrôlant les amplitudes des vecteurs "a" et "b". Mais ce déphaseur analogique est peu fiable, car il est sensible aux paramètres extérieurs.

On connaît également les déphaseurs à lignes commutées par commutateurs PIN, tels que schématisés en figure 2. Un signal E, ayant une certaine phase, est adressé en parallèle sur une ligne directe et sur une ligne dont la longueur peut être modifiée au moyen d'éléments de lignes de longueurs L, L/2, L/4... etc, qui sont commutés par les commutateurs S1,S2,S3... etc. Lorsqu'un commutateur est fermé (S2), il court-circuite l'élément de ligne (L2), qui ne sert pas momentanément, et lorsqu'un commutateur est ouvert (S1,S3), le signal E prend du retard à travers les éléments de lignes (L,L/4), plus longs que la ligne directe. Ce déphaseur numérique fournit deux signaux E et $\overline{E}$ déphasés d'un angle qui varie avec le nombre d'éléments de lignes commutés. La longueur des éléments de lignes fait que ce déphaseur occupe une grande surface sur un circuit intégré, bien qu'il ait une largeur de bande limitée, et soit applicable surtout aux microondes qui ont une petite longueur d'onde, donc de petites lignes commutées.

Le procédé de déphasage selon l'invention est basé sur des sommations vectorielles successives. Le déphaseur qui en découle comprend au moins une fonction de base, divisée en trois opérateurs - ou trois opérations successives si l'on considère le procédé - :

– un additionneur vectoriel fait la somme de deux signaux égaux en amplitude mais de phases différentes. Le signal de sortie a une phase égale à la moitié des deux phases des signaux d'entrée, mais a une amplitude différente,

– un limiteur ou amplificateur modifie l'amplitude du signal de sortie, pour qu'elle soit égale à celle des signaux d'entrée,

– un commutateur sélectionne l'un parmi les trois signaux : deux signaux d'entrée et un signal de sortie.

En répétant l'opération plusieurs fois , on augmente à chaque fois le nombre de signaux disponibles pour le choix, ce qui augmente la précision du déphasage.

Le déphaseur comporte un premier circuit d'initiation qui, à partir d'un unique signal d'entrée E fournit quatre signaux déphasés :

– deux signaux de sortie $\Sigma = E$ et $\overline{\Sigma}$ en opposition de phase,

– deux signaux de sortie Q en quadrature avec $\Sigma$ et $\underline{Q}$ en opposition de phase avec Q.

De façon plus précise, l'invention concerne un procédé de déphasage d'un signal électrique, caractérisé en ce qu'il comporte :

– une opération d'initiation, selon laquelle le signal électrique d'entrée, ayant une phase et une amplitude déterminées, est transformé, au moyen de deux circuits, en quatre signaux électriques ayant même amplitude, mais quatre phases en quadrature, dont l'une a la phase du signal d'entrée

– au moins une opération de sommation vectorielle selon laquelle deux signaux, ayant même amplitude mais des phases différentes, sont sélectionnées parmi les signaux issus de l'opération d'initiation, pour en faire la somme vectorielle dont la phase est égale à la moitié de la somme des phases des deux signaux sélectionnés, mais dont l'amplitude, différente, doit être normalisée pour la ramener à l'amplitude du signal d'entrée, l'un parmi les signaux d'entrée ou de somme vectorielle normalisée, ces trois signaux ayant trois phases différentes, étant sélectionné en sortie au moyen d'un commutateur.

L'invention sera mieux comprise par la description qui suit du procédé et de deux exemples de déphaseurs, en conjonction avec les figures jointes en annexes, qui représentent :

– figures 1 et 2 : procédés de base pour le déphasage analogique ou numérique, selon l'art connu, précédemment exposées,

– figures 3 à 5 : procédé de base pour le déphasage numérique, selon l'invention,

– figures 6 à 9 : schématisation des sommations vectorielles obtenues selon le procédé de déphasage selon l'invention,

– figures 10 et 11 : schémas électriques du circuit d'initiation d'un déphaseur selon l'invention,

– figure 12 : schéma électrique de la fonction de base d'un déphaseur selon l'invention, en version passive,

– figure 13 : schéma électrique de la fonction de base d'un déphaseur selon l'invention, en version active,

– figure 14 : schéma en diagramme de blocs d'un déphaseur selon l'invention, en structure arborescente,

– figure 15 : schéma en diagramme de blocs d'un déphaseur selon l'invention, en structure dite "pipe line ".

Le fondement de l'invention repose sur des sommations vectorielles qui sont en soi connues, mais dont la répétition, ou la multiplicité, dans les opérateurs d'un déphaseur numérique permet d'atteindre une précision de déphasage qui est fonction du nombre opérateurs ou de bits. Les figures 3 à 9 expliquent le fondement de ce procédé de déphasage.

Si l'on considère deux vecteurs E1 et E2, ayant même amplitude mais déphasés, on sait que leur somme vectorielle est un vecteur $\Sigma$ dont la phase est égale à la moitié de la somme des deux phases de E1 et E2, mais dont l'amplitude est différente, selon les angles de phases. La sommation vectorielle $\Sigma$ a sur la figure 3 une amplitude supérieure à celle de E1 ou E2, mais a sur la figure 4 une amplitude inférieure à celle de E1 ou E2: l'exception $\Sigma$ = E1 = E2 n'est contrôlée que pour les angles de phases égaux ou multiples de 120°.

Les vecteurs E1 et E2 peuvent être des signaux électriques, et par convention le signal E2 est déphasé par rapport au signal E1.

La première opération du procédé consiste donc à faire la somme vectorielle de deux signaux E1 et E2 égaux en amplitude, mais déphasés (fig. 3 ou 4) et la deuxième opération, représentée en figure 5, consiste à modifier la somme obtenue pour lui donner la même amplitude unité $\Sigma 1$ que les signaux d'entrée E1 et E2. Par conséquent, $\Sigma$ doit être limitée -c'est ce qui est représenté en figure 5 qui correspond à la figure 3 - ou amplifiée : ce serait le cas de la figure 4.

On sait par ailleurs obtenir, par des moyens électriques simples, les vecteurs en quadrature de phase et d'antiphase d'un vecteur initial. Par exemple, sur la figure 6 qui reprend les mêmes vecteurs E1 et E2, qui ont deux phases différentes, on sait obtenir la somme vectorielle E1 + E2 et les différences vectorielles E1-E2 et E2-E1 en quadrature de phase et d'antiphase avec la somme E1 + E2. On sait également obtenir le vecteur $\overline{E1 + E2}$ en opposition de phase avec E1 + E2 : à partir des deux phases de E1 et E2, on a maintenant déterminé six angles de phases.

La troisième opération consiste à choisir parmi les vecteurs disponibles, ou ce qui revient au même parmi les angles de phases disponibles, deux vecteurs pour en faire à nouveau la sommation vectorielle, et obtenir de nouveaux angles de phases. Ce choix est opéré au moyen d'un commutateur qui, pour chaque fonction de base, permet de choisir entre E1,E2 et leur somme. Par itérations successives, on obtient un angle de déphasage d'autant plus précis que le déphaseur a d'opérateurs.

Il faut cependant remarquer que le procédé exposé porte sur la sommation de deux signaux E1 et E2, tandis qu'un déphaseur fournit un signal de sortie S déphasé d'une valeur déterminée par rapport à un unique signal d'entrée E. C'est pourquoi le procédé comporte une opération préliminaire -et le déphaseur comporte un premier opérateur - qu'on conviendra d'appeler d'"initiation", c'est à dire qui initie la multiplication des angles de phases.

A partir d'un signal électrique E, on sait facilement obtenir les quatre signaux $\Sigma, \overline{\Sigma}, Q$ et $\overline{Q}$ représentés en figure 7, et qui sont en opposition de phase ou en quadrature par rapport à l'un d'eux au choix.

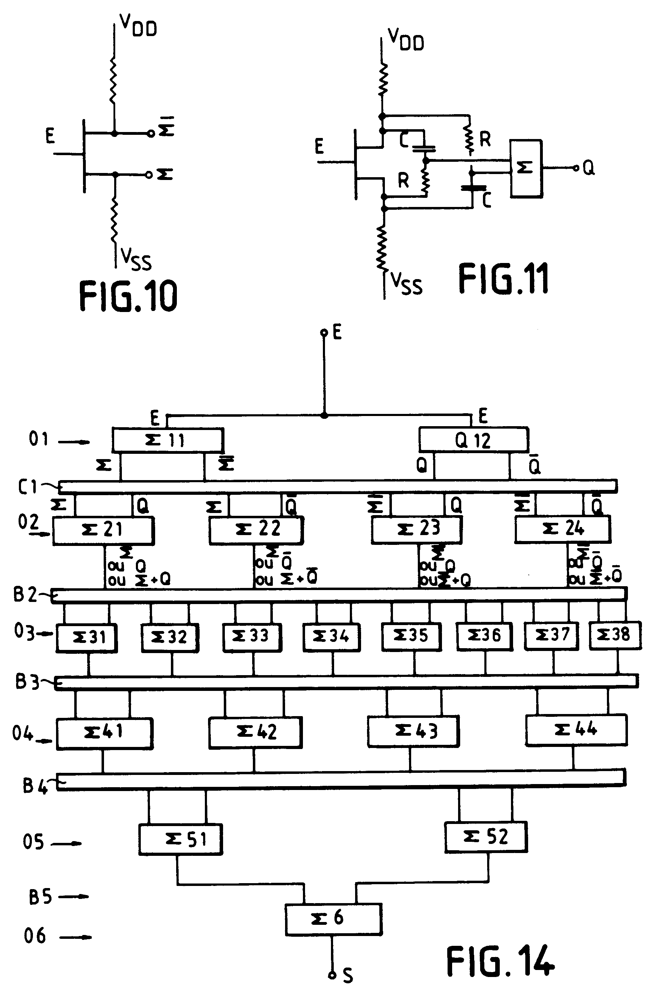

Un simple transistor, -voir figure 10- par exemple à effet de champ, alimenté sur sa source et son drain entre deux sources de tensions $V_{DD}$ et $V_{ss}$, suffit pour fournir deux signaux en opposition de phase. On sait que si l'on applique un signal E sur la grille de ce transistor, le signal de sortie $\Sigma$, prélevé sur la source, est en opposition de phase avec le signal de sortie $\overline{\Sigma}$ prélevé sur le drain.

Par ailleurs, on sait que si on branche, entre source et drain d'un transistor identique, deux réseaux déphaseurs RC montés en antiparallèle, comme représenté en figure 11, les sorties sont en équiphase autour de la quadrature de phase Q avec le signal d'entrée E, et leur somme vectorielle est toujours en quadrature, indépendamment de la fréquence. Pour obtenir le signal $\overline{Q}$ à partir de Q, on opère avec un inverseur, tel que décrit en figure 10. Dans le cas de l'invention, il est plus particulièrement intéressant que Q et $\overline{Q}$ soient en quadrature avec $\Sigma$ et $\overline{\Sigma}$.

Ceci permet, à partir d'un unique signal d'entrée E, d'obtenir quatre signaux $\Sigma, \overline{\Sigma}, Q$ et $\overline{Q}$ qui englobent un déphasage compris entre 0 et 360°, tel que représenté en figure 7 : c'est l'objet et la fonction de l'opérateur d'initiation.

A partir de ces quatre phases, les opérateurs suivants multiplient les phases disponibles- c'est à dire le déphasage par rapport à la phase du signal d'entrée E - en utilisant la sommation suivie d'une amplification ou limitation des signaux, telles qu'exposées en figures 3 et 5.

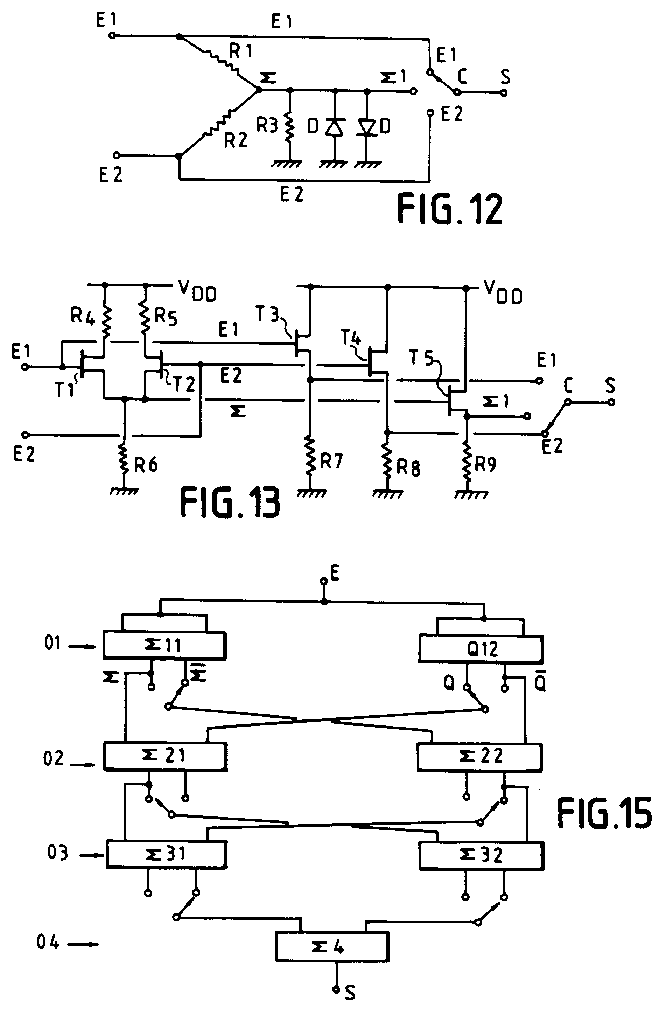

Ainsi, la figure 8 montre les phases disponibles à la sortie du second opérateur : il y a huit phases disponibles. De la même façon, la figure 9 montre les phases disponibles à la sortie du quatrième opérateur : dans le but de simplifier cette figure, les nombres 2,3 et 4 symbolisent les différentes phases en $\Sigma$ et en Q ($\overline{\Sigma}$ et $\overline{Q}$) obtenues en sorties des second, troisième et quatrième opérateurs.

La fonction de base du déphaseur selon l'invention est représentée sous forme passive en figure 12 et sous forme active en figure 13.

La fonction de base de la figure 12 comprend :
– un étage additionneur, constitué par deux résistances R 1 et R 2 qui font la somme $\Sigma$ = E1 + E2 des deux signaux d'entrée E1 et E2.

– un étage limiteur, constitué par une résistance R3 et deux diodes D montées en antiparallèle, qui ramène $\Sigma$ à l'amplitude $\Sigma$1,

– un étage commutateur formé par un commutateur C qui permet de choisir la sortie S parmi les trois signaux E1,E2 ou $\Sigma$1. Ce qui signifie que le signal de sortie S a soit la phase de E1, soit la phase de E2, soit la phase de $\Sigma$1, et a même amplitude que E1,E2.

La fonction de base de la figure 13, réalisée au moyen de transistors, est plus générale : selon que le gain de l'amplificateur est <1 ou >1, il est limiteur (cas de la figure 3) ou amplificateur (cas de la figure 4). Il comprend également

– un étage additionneur, formé par deux transistors T1 et T2, alimentés à travers des résistances R4,R5 et R6. Les signaux E1 et E2 sont appliqués sur les grilles de ces transistors, et la somme $\Sigma$ = E1 + E2 est prélevée au point commun des sources de T1 et T2,

– un étage amplificateur-limiteur, formé par trois transistors T3,T4, T5 montés en parallèle. Les signaux d'entrée E1 et E2 sont appliqués sur les grilles de T3 et T4, par exemple, qui doivent avoir un gain unité pour ne pas modifier l'amplitude de E1 et E2. La somme $\Sigma$ est appliquée sur la grille de T5, qui délivre un signal $\Sigma$1 d'amplitude ramenée à l'unité,

– un étage commutateur, formé par un commutateur C dont la fonction est identique à celle du commutateur de la figure 12. Cependant, la représentation du commutateur est symbolique : la commutation peut se faire, par exemple, au moyen d'une seconde grille avec des transistors bigrilles.

Dans les deux cas de figures 12 et 13, l'étage d'amplification-limitation et l'étage de commutation peuvent être intervertis : leur position préférée est essentiellement une question de technologie de fabrication.

A partir des deux circuits d'initiation représentés en figures 10 et 11, et de l'une ou l'autre des deux fonctions de base décrites ci-dessus, on peut établir un déphaseur numérique dont la précision n'est limitée que par le nombre d'opérateurs en cascades.

La figure 14 représente le schéma d'un déphaseur à structure arborescente. Pour simplifier ce schéma, on a adopté une représentation en blocs $\Sigma_n$ pour les fonctions de base des figures 12 et 13, et en bus $C_n$ pour les interconnexions entre les opérateurs $O_n$.

Dans ce déphaseur numérique selon l'invention, le signal d'entrée E est appliqué aux deux entrées de l'opérateur d'initiation O1. Celui-ci est composé d'un circuit $\Sigma$11, qui est un transistor déphaseur selon la figure 10, et d'un circuit Q12, qui est un transistor déphaseur en quadrature selon la figure 11. Ces deux circuits $\Sigma$11 et Q12 sont branchés en parallèle : l'opérateur d'initiation O1 délivre donc quatre signaux en quadrature $\Sigma$, $\overline{\Sigma}$, Q, $\overline{Q}$ : ce sont ceux de la figure 7.

Un étage de commutation C1 permet de distribuer, deux à deux, ces quatre signaux de phases différentes sur les huit entrées des quatre fonctions de base $\Sigma$21 à $\Sigma$24 du second opérateur O2.

Pour chacune de ces fonctions de bases, conformément aux figures 12 et 13, les signaux d'entrée déphasés sont $\Sigma$, $\overline{\Sigma}$,Q, $\overline{Q}$, pris deux à deux, et les signaux de sortie, après le commutateur, sont choisis parmi $\Sigma$, $\overline{\Sigma}$,Q,$\overline{Q}$, $\Sigma$ + Q, $\overline{\Sigma}$ + $\overline{Q}$, $\overline{\Sigma}$ + Q , $\Sigma$ + $\overline{Q}$ : on dispose donc de huit signaux de phases différentes sur le bus B2 qui les distribue sur les seize entrées des huit fonctions de base $\Sigma$31 à $\Sigma$38 du troisième opérateur $O_3$.

La structure est récurrente, et se répète avec autant d'opérateurs que nécessaire pour obtenir la précision requise pour le déphasage du signal de sortie S par rapport au signal d'entrée E. Il faut néanmoins tenir compte du fait que la précision sur la phase est améliorée à chaque opération : par conséquent la structure arborescente a une certaine symétrie et, pour les derniers opérateurs, chaque opérateur $O_{n+1}$ comporte deux fois moins de fonctions de base $\Sigma_{n+1}$ que l'opérateur précédent $O_n$.

La figure 15 représente un déphaseur selon l'invention, en structure dite "pipe line". Comme pour la figure précédente, il est plus clair de représenter chaque fonction de base par un bloc.

L'opérateur d'initiation O1 est identique à celui d'un déphaseur en structure arborescente, et d'un signal d'entrée E il donne quatre signaux de sortie en quadrature $\Sigma$, $\overline{\Sigma}$,Q, $\overline{Q}$.

Mais ensuite, le déphaseur s'approche de la phase voulue par approximations successives, et chaque opérateur $O_n$ ne comporte que deux fonctions de base, l'une des deux entrées est câblée (par exemple les entrées $\Sigma$ et $\overline{Q}$ sur l'exemple représenté) et l'autre entrée est sélectionnée par un commutateur. Le dernier opérateur, O4 sur l'exemple, ne comporte qu'une seule fonction de base $\Sigma$4 qui délivre un signal S déphasé de la valeur voulue par rapport au signal d'entrée E.

Le déphaseur selon l'invention est préférentiellement utilisé dans le domaine des hyperfréquences, ou microondes, pour les faisceaux hertziens, radars ou télécommunications. Dans sa forme active, il se prête facilement à l'intégration sur puces de silicium ou de GaAs.

## Revendications

1- Procédé de déphasage d'un signal électrique (E1), ayant une phase et une amplitude déterminées, caractérisé en ce que l'on fait au moins une fois la sommation vectorielle ($\Sigma$) de ce premier signal (E1) et d'un second signal (E2), ayant même amplitude mais une phase différente, le troisième signal (Σ) obtenu, équiphase entre les deux signaux (E1,E2) mais d'amplitude différente, étant ramené à l'amplitude des deux premier et second signaux (E1,E2) pour donner un quatrième signal (Σ1), le signal de sortie (S) étant choisi parmi les premier (E1), second (E2) et quatrième (Σ1) signaux.

2- Procédé de déphasage d'un signal électrique, caractérisé en ce qu'il comporte :

– une opération d'initiation, selon laquelle le signal électrique d'entrée (E), ayant une phase et une amplitude déterminées, est transformé, au moyen de deux circuits (Σ11, Q12), en quatre signaux électriques ($\Sigma, \overline{\Sigma}, Q, \overline{Q}$) ayant même amplitude, mais quatre phases en quadrature, dont l'une a la phase du signal d'entrée (E),

– au moins une opération de sommation vectorielle (Σ21) selon laquelle deux signaux (Σ,Q), ayant même amplitude mais des phases différentes, sont sélectionnés parmi les signaux ($\Sigma, \overline{\Sigma}, Q, \overline{Q}$) issus de l'opération d'initiation, pour en faire la somme vectorielle dont la phase est égale à la moitié de la somme des phases des deux signaux (Σ,Q) sélectionnés mais dont l'amplitude, différente, doit être normalisée pour la ramener à l'amplitude du signal d'entrée (E), l'un parmi les signaux d'entrée (Σ,Q) ou de somme vectorielle normalisée (Σ+Q), ces trois signaux ayant trois phases différentes, étant sélectionné en sortie (S) au moyen d'un commutateur (C).

3- Déphaseur d'un signal électrique (E) basé sur le procédé de déphasage de la revendication 2, caractérisé en ce qu'il comporte :

– un opérateur d'initiation (01), comportant d'une part un premier circuit (Σ11) constitué par un premier transistor à effet de champ, sur la grille duquel est appliqué le signal d'entrée (E), ayant une phase et une amplitude déterminées, et qui délivre sur sa source et son drain deux signaux ($\Sigma, \overline{\Sigma}$) en phase et en opposition de phase avec le signal d'entrée (E), et d'autre part, en parallèle avec le premier circuit (Σ11), un second circuit (Q12) constitué par un second transistor à effet de champ, muni de deux réseaux RC de déphasage entre source et drain, qui délivrent deux signaux ($Q, \overline{Q}$) en opposition de phase entre eux mais en quadrature avec les signaux ($\Sigma, \overline{\Sigma}$) délivrés par le premier transistor,

– un commutateur (C1) permettant de sélectionner au moins deux signaux (Σ,Q) parmi les quatre signaux ($\Sigma, \overline{\Sigma}, Q, \overline{Q}$) issus de l'opérateur d'initiation (01), lesdits quatre signaux ayant même amplitude mais des phases différentes,

– au moins un opérateur de sommation vectorielle ($0_2$) comportant au moins un circuit dit "fonction de base" (Σ21) dans lequel un premier étage fait la somme vectorielle de deux signaux d'entrée (Σ,Q) choisis parmi ceux issus du commutateur (C1), un second étage normalise la dite somme vectorielle (Σ+Q) à la même amplitude que les signaux d'entrée (Σ,Q), et un troisième étage (C) sélectionne en sortie (S) l'un parmi les signaux d'entrée (Σ,Q) ou de sommation vectorielle (Σ+Q), qui ont trois phases différentes.

4 - Déphaseur selon la revendication 3, caractérisé en ce que, dans une structure dite "arborescente", il comporte une pluralité d'opérateurs de sommation ($0_2$ à $O_5$) en cascade, chaque opérateur comportant lui-même une pluralité de fonctions de base (Σ21 à 52), la structure de ce déphaseur étant symétrique de sorte qu'une première partie des opérateurs ($0_2, 0_3$) élabore une gamme de phases, et qu'une seconde partie des opérateurs ($0_4, 0_5$) sélectionne parmi les dites phases les deux qui, appliquées sur l'opérateur de sortie (06), donnent au signal de sortie (S) le déphasage désiré par rapport au signal d'entrée (E).

5- Déphaseur selon la revendication 3, caractérisé en ce que, dans une structure dite " pipe-line ", il comporte une pluralité d'opérateurs de sommation (02,03) en cascade, chaque opérateur comportant deux fonctions de base (Σ21 et Σ22) (Σ31 et Σ32), l'angle de déphasage désiré pour le signal de sortie (S) sur l'opérateur de sortie (06) qui ne comporte qu'une seule fonction de base (Σ4), étant obtenu par approximations successives, au moyen des commutateurs (C) qui, à la sortie d'un opérateur, sélectionnent les deux phases les mieux appropriées, pour obtenir la phase du signal de sortie (S) par rapport à la phase du signal d'entrée (E).

FIG.1

FIG.2

FIG.3

FIG.4

FIG.5

FIG.6

FIG.7

FIG.8

FIG.9

FIG.12

FIG.13

FIG.15

FIG.10

FIG.11

FIG.14

Office européen
des brevets

# RAPPORT DE RECHERCHE EUROPEENNE

Numero de la demande

EP    91 40 3510

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-4 506 231 (D.R.GREEN) 19 Mars 1985<br>* colonne 2, ligne 19 - colonne 2, ligne 51; figure 1 *<br>--- | 1 | H03H11/22 |
| A | US-A-4 806 888 (S.T.SALVAGE E.A.) 21 Février 1989<br>*LE DOCUMENT EN ENTIER*<br>--- | 1 | |
| A | EP-A-0 308 844 (FUJITSU) 29 Mars 1989<br>--- | | |
| P,X | WO-A-9 110 286 (ALCATEL) 11 Juillet 1991<br>ABSTRACT<br>* page 3, ligne 1 - page 4, ligne 21; figures 1,2 *<br>----- | 1 | |
| | | | **DOMAINES TECHNIQUES RECHERCHES (Int. Cl.5 )**<br><br>H03H |

Le présent rapport a été établi pour toutes les revendications

| Lieu de la recherche | Date d'achèvement de la recherche | Examinateur |
|---|---|---|
| LA HAYE | 03 AVRIL 1992 | COPPIETERS C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)